# EUROPEAN PATENT APPLICATION

(11) **EP 1 905 863 A2**
(43) Date of publication of application: **02.04.2008**
(21) Application number: 07017911.4
(22) Date of filing: 12.09.2007
(51) Int. Cl.: C23C 14/02, C23C 14/06

(54) **Slide member**

(30) Priority: 26.09.2006 JP 2006259866
(71) Applicant: Hitachi, Ltd., Chiyoda-ku Tokyo 100-8220 (JP)
(72) Inventor: Okamoto, Shinya, c/o Hitachi, Ltd., Tokyo 100-8220 (JP); Nakashima, Shoichi, c/o Hitachi, Ltd., Tokyo 100-8220 (JP); Baba, Noboru, c/o Hitachi, Ltd., Tokyo 100-8220 (JP); Yamaguchi, Shizuka, c/o Hitachi, Ltd., Tokyo 100-8220 (JP)
(74) Representative: Kirschner, Klaus Dieter

(57) **Abstract**

A slide member according to the present invention includes: a substrate of at least one element selected from a group made up of V, Cr, Fe, Co, Ni, Zr, Nb, Mo, Ta, W, Ir and Pt; a gradient layer containing chromium and carbon formed on the substrate; and a hard carbon coating layer formed on the gradient layer, in which the graded layer has a component conformation comprising a gradually decreasing chromium concentration and gradually increasing carbon concentration from the substrate side to the hard carbon coating layer side, and the hard carbon coating layer contains aluminum.

## Description

### BACKGROUND OF THE INVENTION

### 1. FIELD OF THE INVENTION

The present invention relates to slide members comprising a hard carbon coating with a low friction.

### 2. DESCRIPTION OF RELATED ART

Hard carbon coatings generally have features of a high hardness, a smooth surface, excellent friction resistance, and a low coefficient of friction; and these excellent friction properties are attributed to their solid lubricity. Under unlubricated condition, the surface friction coefficient is 0.5 to 1.0 for the smooth surface of typical steel and approximately 0.4 for conventional surface treatment materials such as Ni-P or Cr plating, and TiN or CrN coating; while hard carbon coatings have a surface friction coefficient of approximately 0.12.

Currently, by utilizing these excellent characteristics, high-hardness carbon coatings are applied to a lot of slide members used under unlubricated condition such as cutting instruments including a drill blade, jigs for grinding tools, dies for plastic working, valve cocks, or capstan rollers. On the other hand, oil lubricated sliding members are now dominant in machine components such as components used in an internal combustion engine, which is required to reduce mechanical loss as much as possible in the viewpoint of energy consumption and environmental considerations.

Hereupon, if low friction properties can be achieved in the machine components by using hard carbon coatings having these solid lubricities under unlubricated condition, it can reduce load of the oil lubricated machine components even when the lubricating oil runs short. In addition, it would also be preferable in the viewpoint of environmental considerations because consumption of the lubricating oil could be reduced in the future.

A slide member comprising a diamond-like carbon layer as a hard carbon coating is described in JP-A-2004-010923 and JP-A-2000-256850. However, such conventional slide members comprising a diamond-like carbon layer have a problem in that they do not always provide a low coefficient of friction under the unlubricated condition. Furthermore, there is another problem that they are subject to partial peeling or surface roughness of the layer in a durability test under an oil lubricated condition.

### SUMMARY OF THE INVENTION

Under these circumstances, it is an object of the present invention to provide a slide member comprising a hard carbon coating layer with excellent abrasion resistance and low friction properties even under an unlubricated condition.
(1) According to one aspect of the present invention, a slide member comprises: a substrate containing at least one element selected from a group made up of V (vanadium), Cr (chromium), Fe (iron), Co (cobalt), Ni (nickel), Zr (zirconium), Nb (niobium), Mo (molybdenum), Ta (tantalum), W (tungsten), Ir (iridium) and Pt (platinum); a gradient layer containing chromium and carbon formed on the substrate; and a hard carbon coating layer (diamond like carbon layer) formed on the gradient layer. Further, in the gradient layer, Cr concentration decreases gradually and C concentration increases gradually from the substrate side to the hard carbon coating layer side; and the hard carbon coating layer contains aluminum.
(2) According to another aspect of the present invention, a method for manufacturing a slide member includes the steps of: forming a Cr intermediate layer on a substrate that contains at least one element selected from the group made up of V, Cr, Fe, Co, Ni, Zr, Nb, Mo, Ta, W, Ir and Pt; forming on the Cr intermediate layer a gradient layer in which Cr concentration decreased gradually and C concentration increases gradually by a sputtering or ion plating method; and forming on the graded layer a hard carbon coating layer (diamond like carbon layer) containing aluminum.

In the above inventions (1) and (2), the following modifications and changes can be made.
(i) The gradient layer is made of Cr metal containing C or chromium carbide, and has a thickness of 0.15 to 6.0 µm*.*
(ii) The hard carbon coating layer has a thickness of 0.15 to 6.0 µm, a surface hardness of 20 to 140 GPa, and a surface Young's modulus of 50 to 180 GPa. Further, the hard carbon coating layer has an average surface roughness of 0.1 µm or less.
(iii) The hard carbon coating layer contains aluminum in an amount of 0.5 to 4.5 at.%; and the aluminum in the hard carbon coating layer is in the form of at least one material selected from a group made up of metallic Al, Al boride, Al carbide, Al nitride, Al oxide and Al hydroxide.
(iv) The hard carbon coating layer contains both sp² bonded carbon and sp³ bonded carbon in its outermost surface layer.
(v) The hard carbon coating layer contains silicon.
(vi) A chromium intermediate layer is formed between the substrate and the gradient layer. The intermediate layer preferably has a thickness of 0.03 to 1 µm.

### [Advantages of the Invention]

According to the present invention, it is possible to provide a slide member comprising a hard carbon coating layer with excellent abrasion resistance and low friction properties.

### BRIEF DESCRIPTION OF THE DRAWINGS

Fig. 1 is a schematic illustration showing a perspective view of a test specimen with a hard carbon coating layer formed thereon.
Fig. 2 is a schematic illustration showing a sectional view of an abrasion tester used for evaluation in an embodiment of the present invention.
Fig. 3 is a schematic illustration showing a perspective view of a sliding portion between a test specimen and a ball of the abrasion tester used for evaluation in an embodiment of the present invention.
Fig. 4 is a schematic illustration showing a partial cross sectional view of a test specimen comprising a hard carbon coating layer formed on a substrate.
Fig. 5 is a graph indicating a method for controlling with time powers input to Cr and C targets and a bias voltage applied to a substrate when forming a gradient layer of Example 1 and Comparative example 2.
Fig. 6 is a graph indicating a method for controlling with time powers input to Cr and C targets and a bias voltage applied to a substrate when forming a gradient layer of Comparative example 1.
Fig. 7 is a graph indicating a method for controlling with time powers input to Cr and C targets and a bias voltage applied to a substrate when forming a gradient layer of Comparative example 3.
Fig. 8 is a photograph of a plan view of a trace forced into a carbon coating layer, which exhibits no peeling in an adhesiveness evaluation using a Rockwell diamond indenter.
Fig. 9 is a photograph of a plan view of a trace forced into a carbon coating layer, which exhibits some amount of peeling in an adhesiveness evaluation using a Rockwell diamond indenter.
Fig. 10 is a result of a surface shape measurement on a carbon coating layer applied to a crown surface of a motor vehicle cam lifter, which exhibits no peeling nor abrasion, after a friction torque measurement in a durability test under an oil lubricated condition.
Fig. 11 is a result of a surface shape measurement on another carbon coating layer applied to a crown surface of a motor vehicle cam lifter, which exhibits peeling or abrasion at some portions thereof, after a friction torque measurement in a durability test under an oil lubricated condition.
Fig. 12 is a result of a surface shape measurement on another carbon coating layer applied to a crown surface of a motor vehicle cam lifter, which exhibits peeling or abrasion over its entire surface, after a friction torque measurement in a durability test under an oil lubricated condition.
Fig. 13 is a schematic illustration of a simulation test device of a motor vehicle cam lifter.

### DETAILED DESCRIPTION OF THE PREFERRED EMBODYMENT

A preferred embodiment of the present invention will be described below with reference to the drawings. However, the present invention is not limited to the embodiment described herein.

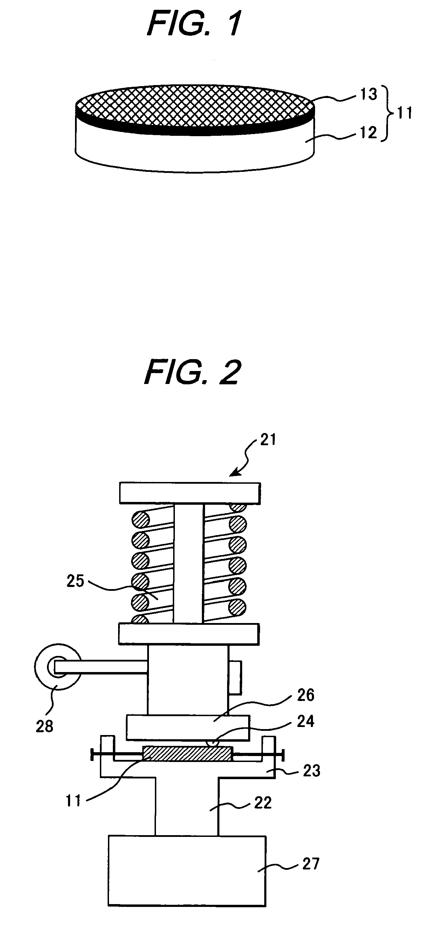

A hard carbon coating layer according to this embodiment of the present invention can be applied to slide members such as machine components used under an unlubricated condition. Fig. 1 is a schematic illustration showing a perspective view of a test specimen with a hard carbon coating layer formed thereon. A hard carbon coating layer 13 was evaluated for the adhesiveness, hardness and Young's modulus using a test specimen 11, which comprises the hard carbon coating layer 13 formed on a disc substrate 12 having a diameter of 21.5 mm and a thickness of 5.2 mm as shown in Fig. 1.

The test specimens 11 were prepared by forming the hard carbon coating 13 on the substrate 12 using the conditions (Al content, applied bias voltage, and conformation of the gradient layer) shown in Table 1.

**Table 1**

| | Al Content [at.%] | Applied Bias Voltage [V] | Gradient Layer | Peeling of Coating after Indentation Test Using Rockwell diamond indenter | Hardness [GPa] | Young's Modulus [GPa] | Coefficient of Friction µ | Friction Test under Unlubricated Condition Peel Load [N] | Friction Torque Test under Oil Lubricated Condition Torque Reduction Rate | Peeling of Coating after Durability Test under oli Lubricated Condition |
|---|---|---|---|---|---|---|---|---|---|---|
| Example 1 | 1.88 | 100 | Linear | None | 27.82 | 158.7 | 0.046 | 588 | 47% | None |
| Comparative example 1 | 0 | 100 | Stepwise | Observed | - | - | - | - | - | - |
| Comparative example 2 | 0 | 100 | Linear | None | 30.23 | 178.70 | 0.090 | 981 | 43% | Partial Peeling and Roughness |
| Comparative example 3 | 0.65 | 50 | Linear | None | 9.378 | 65.94 | 0.052 | ≥ 2452 | -3% | Peeling |

The hard carbon coating layer 13 was formed by depositing a diamond-like carbon (DLC) layer on the substrate 12 using an unbalanced magnetron sputtering (UBMS) method. The UBMS method is a film forming method having the following features. Magnetic poles disposed behind a target are intentionally unbalanced in magnetic strength between at the center and periphery of the target to produce a nonequilibrium state, thereby causing a part of the magnetic line of force from the magnetic pole at the periphery of the target to extend to a substrate. This, in return, helps plasma conventionally concentrated in the vicinity of the target to diffuse along the extended magnetic line of force. Therefore, the substrate 12 can be irradiated with an increased amount of ions during the formation of the hard carbon coating layer 13, thereby enabling the denser coating layer 13 to be formed on the substrate 12.

After forming the hard carbon coating layer (henceforth referred to as "coating layer") 13, it was evaluated for the adhesiveness by examining for peeling of the coating layer 13 in an indentation test using a Rockwell diamond indenter. The surface of the coating layer 13 was also evaluated by a nano indentation method (ISO14577), and was measured for the peel load by a friction test under an unlubricated condition. On the other hand, the coating layer formed on a crown surface of a cam lifter for automotive engines was measured for the friction torque under an oil lubricated condition to calculate reduction rate of the torque, and the coating layer 13 was also examined for peeling after a durability test under the oil lubricated condition.

In the adhesiveness evaluation by an indentation test using a Rockwell diamond indenter, a conical Rockwell diamond indenter having a tip diameter of 200 µm was pushed into the test specimen at a force of 1471 N (150 kgf). A trace produced by the pushing was observed for cracking and peeling of the coating layer 13 around the trace with an optical microscopy.

In the nano indentation (ISO14577) evaluation, a triangular pyramidal Berkovich indenter having a dihedral angle of 115 degrees was forced into the surface of the coating layer 13 for 10 seconds up to a maximum load of 3 mN, which was maintained for 1 second and then the force was unloaded over a period of 10 seconds. The indentation hardness and the indentation Young's modulus were calculated from this evaluation.

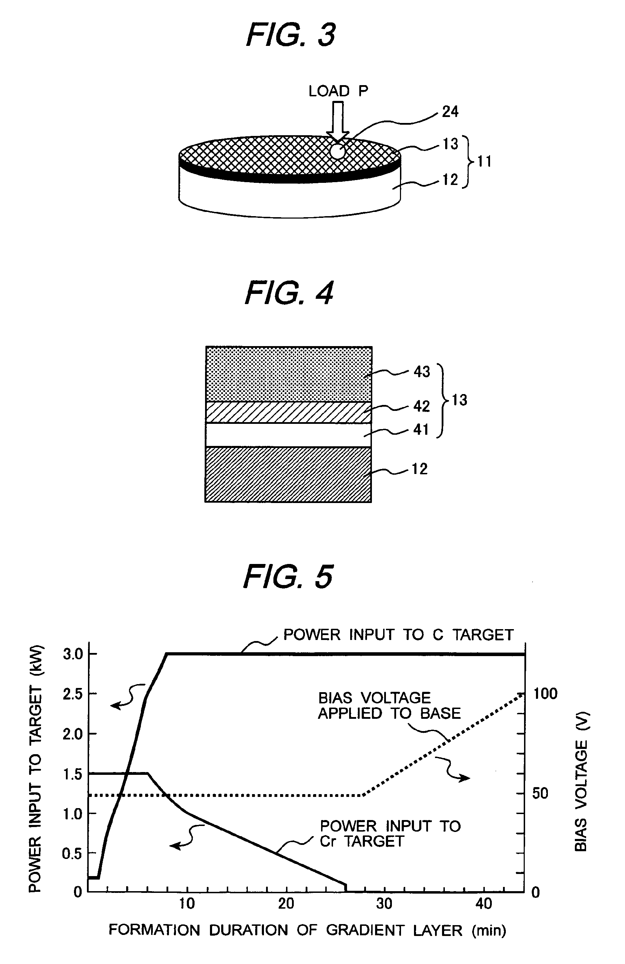

Fig. 2 is a schematic illustration showing a sectional view of an abrasion tester 21 used for evaluation in an embodiment of the present invention; and Fig. 3 is a schematic illustration showing a perspective view of a sliding portion between a test specimen 11 and a ball 24 of the abrasion tester used for the evaluation. The friction test under an unlubricated condition was performed using an evaluation device (an abrasion tester 21) as shown in Fig. 2. And the coating layers 13 were measured for the coefficient of friction and the peel load with this abrasion tester (ball-on-disk type abrasion tester) 21.

The tester 21 is provided with a work table 23 fixed to a rotating shaft 22. On the work table 23 is loaded the test specimen 11, on the upper side of which is placed a 6mm-diameter metal ball (high carbon chromium bearing steel ball) 24 as the counterpart of the test specimen 11. Here, a metal material used for the metal ball 24 is not limited to the high carbon chromium bearing steel, but may be any steel used for bearings.

The tester 21 is so configured that a spring 25 is used to increase the applied load stepwise by 98 N every one minute from 98 to 2452 N. Here, the metal ball 24 is fixed to a holder 26 to prevent the rotation of the ball. The rotating shaft 22 driven by a motor 27 was rotated at a sliding velocity of approximately 34 mm/sec relative to the metal ball 24, and the torque corresponding to the friction force generated between the metal ball 24 and test specimen 11 was measured by a load cell 28 to calculate the coefficient of friction. In addition, one metal ball 24 is disposed 8 mm from the rotation center and a load of P is applied to it as shown in Fig. 3. The peel load value of the coating layer 13 was defined as a test load value at which the coefficient of friction between the test specimen 11 and the metal ball 24 abruptly increased. Furthermore, this friction test was performed under an unlubricated condition at room temperature and normal humidity (room temperature: approximately 25°C, humidity: approximately 60% RH).

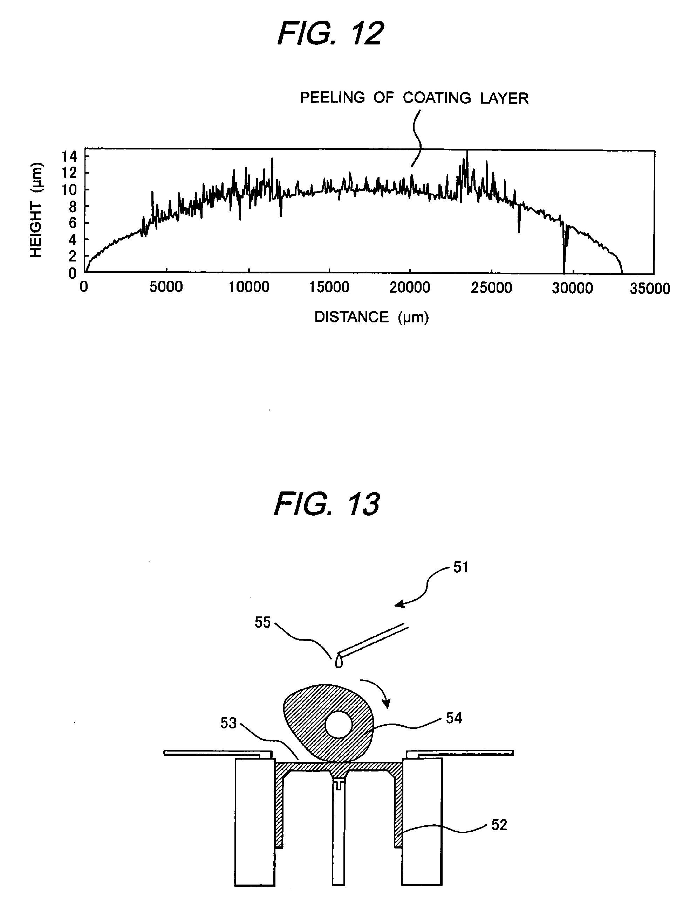

Fig. 13 is a schematic illustration of a simulation test device of a motor vehicle cam lifter. The friction torque measurement in the durability test under an oil lubricated condition was performed using a simulation test device 51 as shown in Fig. 13. The test conditions were as follows: a cam 54 was rotated at 300 rpm while an engine oil 55 (SAE 5W-30, 80°C) was dropped thereon, and the torque applied to the cam shaft was measured after 2 hours from the start of the test. After this test, the coating layer formed on a crown surface 53 of a motor vehicle cam lifter 52 was examined for peeling by a surface shape measurement.

### [Example 1]

The disk substrate 12 of an alloy (chromium molybdenum steel) containing Fe, Cr and Mo was carburized to have a Rockwell C scale surface hardness (HRC) of 58 or more, and was dressed to have an average surface roughness (Ra) of 0.1 µm or less. Then, a coating layer 13 was formed by an UBMS method while introducing inert and hydrocarbon gases so as to have an Al content of 1.88 at.%.

Fig. 4 is a schematic illustration showing a partial cross sectional view of a test specimen 11 comprising the coating layer 13 formed on the substrate 12. As shown in Fig. 4, the coating layer 13 has a Cr intermediate layer 41, an outermost surface layer 43 and a gradient layer 42 disposed between the intermediate layer 41 and the outermost surface layer 43. When forming the gradient layer 42, the powers input to the Cr and C targets and bias voltage applied to the substrate were controlled as shown in Fig. 5. Fig. 5 is a graph indicating a method for controlling with time powers input to Cr and C targets and a bias voltage applied to a substrate when forming a gradient layer of Example 1 and Comparative example 2.

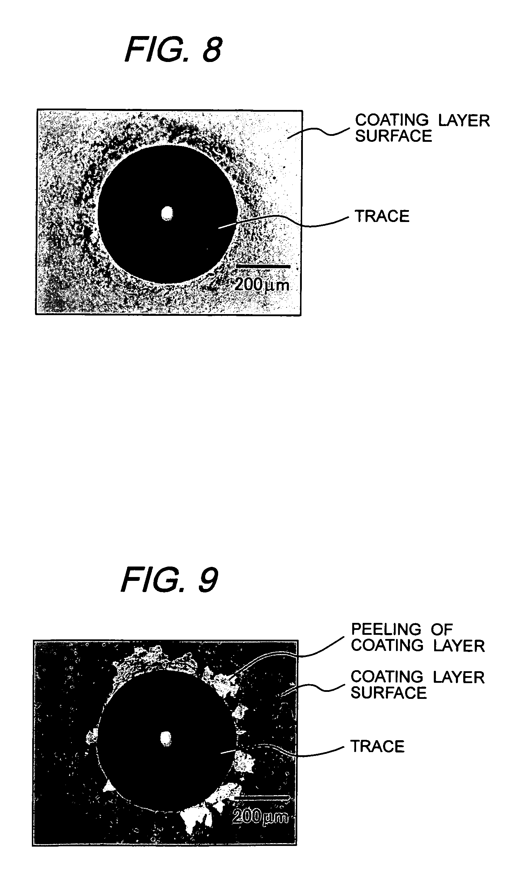

The formed coating layer 13 was evaluated for the adhesiveness by forcing the Rockwell diamond indenter into the coating layer at a load of 1471 N. The result showed excellent adhesiveness between the substrate 12 and the coating layer 13 because no peeling was observed around the trace as shown in Fig. 8. Fig. 8 is a photograph of a plan view of a trace forced into the coating layer 13, which exhibits no peeling in an adhesiveness evaluation using a Rockwell diamond indenter. In addition, it was revealed that the coating layer 13 had a hardness of 27.82 GPa and a Young's modulus of 158.7 GPa. Further, the coefficient of friction and peel load of the coating layer 13 were determined to be 0.046 and 588 N respectively from the result of the friction test between the coating layer 13 and a metal ball 24 under an unlubricated condition.

The coating layer 13 of Example 1 is not subject to any peeling from the substrate 12 so that the substrate 12 is never exposed, thus enabling efficient use of the low friction properties of the coating layer 13. When the coating layer 13 of Example 1 was subject to an unlubricated sliding movement, the coefficient of friction was 0.1 or less, meaning that the coefficient of friction could be reduced by approximately 88 to 96% compared to steel without the coating layer 13 or with conventional surface treatments, and could be reduced by approximately 62% compared to conventional coating layers. Moreover, the peel load of the coating layer 13 is as large as 490 N or more, thereby enabling efficient use of the low friction properties of the coating layer 13 even under higher load condition than usual.

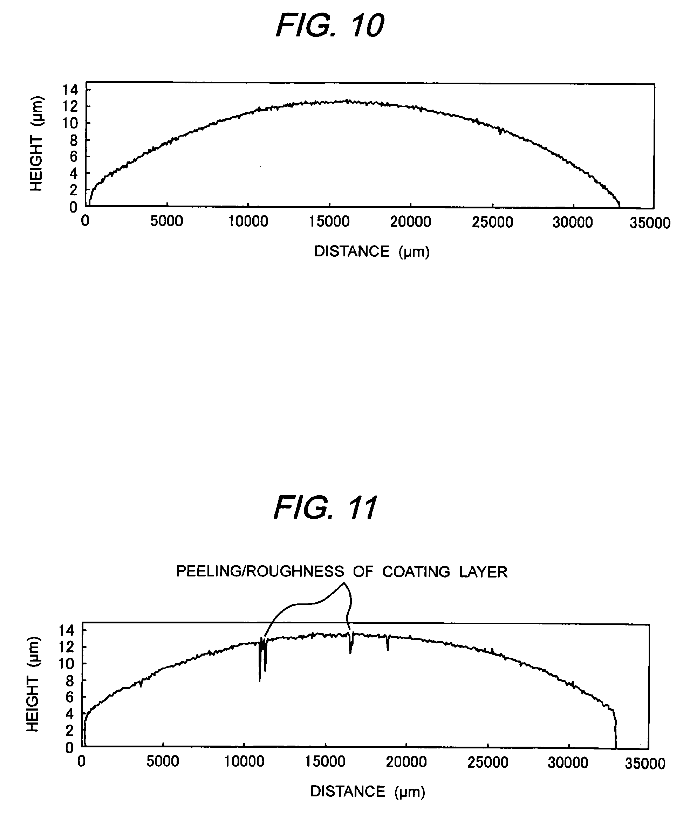

On the other hand, as a test specimen under an oil lubricated condition, the coating layer 13 was applied to a crown surface 53 (carburized to have an HRC value not less than 58 and dressed to have an Ra value not more than 0.1 µm) of a motor vehicle cam lifter 52 as shown in Fig. 13 by an UBMS method while introducing inert and hydrocarbon gases similarly to the case of the substrate 12. The result of the friction torque measurement in durability test under an oil lubricated condition was that in the case of Example 1, the torque could be reduced by approximately 47% compared to a typical torque for motor vehicle cam lifters without the coating layer 13. Further, after the test, the coating layer 13 formed on the crown surface 53 exhibited no peeling as can be seen from Fig. 10. Fig. 10 is a result of a surface shape measurement on the coating layer 13 applied to the crown surface 53 of the motor vehicle cam lifter 52, in Example 1, after the friction torque measurement in the durability test under the oil lubricated condition.

Applying the coating layer 13 of Example 1 to the motor vehicle cam lifter 52 reduces the torque applied thereto, thus reducing the slide load between the cam lifter 52 and a cam 54. Furthermore, there is produced no peeling of the coating layer 13, thus enabling continuous use of the low friction properties of the coating layer 13. This can provide a motive power engine (such as an automotive engine) capable of maintaining a high energy efficiency due to a low mechanical loss over a long period of time. The coating layer 13 of Example 1 is not subject to any peeling from the substrate 12 (the crown surface 53 of the cam lifter 52 for automotive engines) so that the substrate 12 is never exposed, thus enabling efficient use of the low friction properties of the coating layer 13.

The coating layer 13 of Example 1 is a hard carbon coating layer containing both sp² bonded carbon typified by the carbon bond of graphite and sp³ bonded carbon typified by the carbon bond of diamond. This can provide the coating layer 13 having both abrasion resistance and low friction properties. A hard carbon coating layer is made of amorphous carbon or hydrogenated carbon, and is called amorphous carbon, hydrogenated amorphous carbon (a-C:H), diamond-like carbon (DLC) or the like. The method for forming the hard carbon coating layer includes: plasma CVD (chemical vapor deposition) in which hydrocarbon gas is decomposed by plasma to form a film; vapor phase synthesis such as ion beam deposition using carbon or hydrocarbon ions; ion plating in which graphite or the like is vaporized by arc discharge to form a film; and sputtering in which a target is sputtered in an inert atmosphere to form a film.

The coating layer of Example 1 combines excellent adhesiveness, abrasion resistance and low friction properties, thereby rendering the coating applicable to slide members. Accordingly, this can provide a slide member capable of reducing load under an unlubricated condition as well as under water, organic solvent, fuel and oil lubricated conditions. In addition, a machine component normally sliding in a lubricating oil can maintain its reliability even when the lubricating oil runs short, thus reducing the amount of lubricating oil.

In the present invention, the substrate 12 having the coating layer 13 formed thereon preferably contains at least one element selected from the group made up of V, Cr, Fe, Co, Ni, Zr, Nb, Mo, Ta, W, Ir and Pt. Furthermore, because the temperature rises during the formation of the coating layer 13, it more preferably contains a high melting point metal (in particular, Fe, Co and Ni) to prevent the transformation of the substrate. The Cr intermediate layer 41 is also formed before forming the hard carbon coating layer. Therefore, the substrate preferably contains Cr to improve adhesiveness between the substrate 12 and the Cr intermediate layer 41.

The gradient layer 42 formed between the Cr intermediate layer 41 and outermost surface layer 43 preferably has a continuously decreasing Cr concentration and continuously increasing C concentration from the Cr intermediate layer 41 side to the outermost surface layer 43 side. In the case where the gradient layer 42 is formed by stacking layers of a different composition (different Cr and C contents), each layer preferably has a thickness of 15 nm or less. If Cr carbide, one of the materials composing the gradient layer 42, is expressed as CrₓC_{y}, its composition can be gradually varied from the Cr intermediate layer 41 side to the outermost surface layer 43 side by gradually varying the ratio of x and y. Therefore, it prevents abrupt change in film characteristic in the thickness direction of the gradient layer 42.

When a thickness of the coating layer 13 is less than 0.15 µm, the layer is more prone to be worn away by sliding movement. While, a thickness of the coating 13 is more than 6.0 µm, the layer has a higher internal stress and is thereby more prone to peel off. Therefore, the coating layer 13 preferably has a thickness within a range of 0.15 to 6.0 µm. Since the coating layer 13 has a high surface hardness, the greater the average surface roughness is above 0.1 µm, the more likely it is to wear away the counterpart. Therefore, the coating layer 13 preferably has an average surface roughness of 0.1 µm or less. Additionally, when the thicknesses of the gradient layer 42 and the outermost surface layer 43 are denoted by d_{G} and d_{C} respectively, it is preferred that d_{C}/d_{G} s 1.

The coating layer 13 is preferably formed by sputtering, plasma CVD, ion plating or the like, more preferably formed by sputtering or ion plating. In addition, the coating layer 13 contains Al in the outermost surface layer 43. Its content is preferably within a range of 0.5 to 4.5 at.%, more preferably within a range of 0.6 to 1.9 at.%. The Al is contained in the form of at least one material selected from the group made up of Al metal, Al boride, Al carbide, Al nitride, Al oxide and Al hydroxide, and preferably in the form of Al oxide and/or Al hydroxide.

This can offer a hard carbon coating layer having both abrasion resistance and low friction properties. The test specimen 11 formed according to Example 1 combines excellent adhesiveness, abrasion resistance and low friction properties, and is thus applicable to slide members. Accordingly, this can provide a slide member capable of reducing load under an unlubricated condition as well as under water, organic solvent, fuel and oil lubricated conditions. Also, a machine component normally sliding in a lubricating oil can maintain its reliability even when the lubricating oil runs short, thus reducing the amount of lubricating oil.

Al exposed on the surface of the coating layer 13 reacts with oxygen, water or the like in the atmosphere to form an Al oxide or Al hydroxide, thereby also providing a dielectric coating layer with stable electrical properties although it contains metal. As a result, Al contained in such a coating layer 13 is present on its surface in the form of Al oxide and/or Al hydroxide. That is, the coating layer 13 (in particular, the outermost surface layer 43) has a hydrophilic surface, thereby enabling realization of low friction properties in a water lubricated sliding movement. This also permits realization of low friction properties in a sliding movement under the presence of liquid or steam having the same OH-group as water (e.g., alcohols or additives in oil). Example 1 is actually based on the discovery of a phenomenon in which the presence of Al in the coating layer 13 reduces its internal stress, thereby causing it less likely to be peeled away from the substrate 12.

When a surface Al content of the coating layer 13 is less than 0.5 at.%, the outermost surface layer contains less amount of Al oxide and/or Al hydroxide from which the hydrophilicity is derived, and thus cannot be expected to produce a friction reducing effect. It was found from the result of X-ray photoelectron spectroscopy (XPS) that there was possible carburization of Al for the coating layer 13 having Al content more than 5 at.% on its surface (particularly the surface and inside of the outermost surface layer 43). That is, the coating layer 13 having a surface Al content more than 5 at.% produces more Al carbides, making the coating layer 13 more prone to cracking due to the embrittlement of the Al carbides.

A surface hardness of the coating layer 13 is more than 20 GPa. The surface hardness less than 20 GPa lowers the abrasion resistance, thus making the coating layer 13 more prone to abrasion. Addition of Al to the coating layer 13 tends to lower the hardness of the layer compared to the case without such addition. However, addition of Si (silicon) with Al to the layer is effective to increase the hardness. Furthermore, a surface Young's modulus of the coating layer 13 is within a range of 50 to 180 GPa. The Young's modulus is increased by the formation of Al carbides, but when it exceeds 180 GPa, the coating layer 13 is more prone to cracking or peeling. On the other hand, when the Young's modulus is less than 50 GPa, it lowers the load bearing properties in a sliding movement.

In the case where Al contained in the coating layer 13 is present in the form of Al oxide and/or Al hydroxide, the coating layer 13 has a high affinity to liquid or steam with OH-groups, thus enabling realization of low friction properties under a water lubricated condition. The coating layer 13 containing Al can be formed by using an Al target in the case of sputtering or ion plating. On the other hand, in the case of plasma CVD, an organic Al compound typified by trimethylaluminum can be introduced as gas into the chamber to form the coating layer 13 containing Al.

A high adhesiveness to the substrate 12 can be realized by using the hard carbon coating layer 13 in which the gradient layer 42 has a decreasing Cr concentration and increasing C concentration from the Cr intermediate layer 41 side to the outermost surface layer 43 side, and further the outermost surface layer 43 contains Al. Such a coating layer can be used not only under an unlubricated condition, but also under water, organic solvent, fuel and oil lubricated conditions. In addition, the gradient layer 42 preferably has a continuously decreasing Cr concentration and continuously increasing C concentration from the Cr intermediate layer 41 side to the outermost surface layer 43 side. Further, the gradient layer 42 preferably has a thickness within a range of 0.25 to 5.0 µm.

The outermost surface of the coating 13 (the outermost surface layer 43) contains at least Al, or contains both Al and Si. Additionally, the coating layer 13 preferably has a total thickness within a range of 0.5 to 4 µm. A slide member according to a preferred embodiment of the present invention can be applied to applications that require durability, e.g., motor vehicle slide components (in particular, engine cylinders), and vanes for refrigerant compressors or rotary compressors used in refrigerators, air conditioners, etc.

### [Comparative Example 1]

A disk substrate 12 made of JIS SCM415 was carburized to have a surface hardness HRC not less than 58, and was dressed to have an average surface roughness Ra not more than 0.1 µm. Here, "JIS SCM415" is a kind of chromium molybdenum steels and contains 0.13-0.18 wt.% of C; 0.15-0.35 wt.% of Si; 0.60-0.90 wt.% of Mn; 0.90-1.20 wt.% of Cr; 0.15-0.25 wt.% of Mo; not more than 0.030 wt.% of P; not more than 0.030 wt.% of S; not more than 0.25 wt.% of Ni; and not more than 0.30 wt.% of Cu.

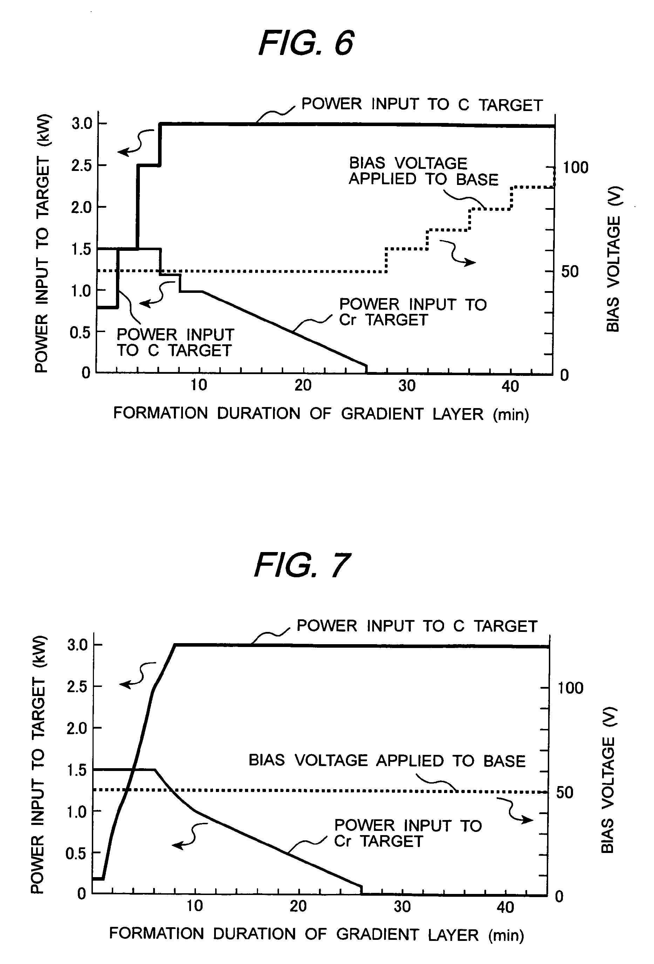

Then, a coating layer 13 was formed by an UBMS method while introducing inert and hydrocarbon gases. Al was not added to the coating layer 13 of Comparative example 1. When forming a gradient layer 42 positioned between a Cr intermediate layer 41 and an outermost surface layer 43 of the coating layer 13, the powers input to the Cr and C targets and the bias voltage applied to the substrate were controlled as shown in Fig. 6. Fig. 6 is a graph indicating a method for controlling with time powers input to the Cr and C targets and the bias voltage applied to the substrate 12 when forming the gradient layer 42 of Comparative example 1.

The formed coating layer 13 was evaluated for the adhesiveness by forcing the Rockwell diamond indenter into the coating layer at a load of 1471 N. The result showed a poor adhesiveness between the substrate 12 and the coating layer 13 because some peeling was observed around the trace in the coating layer 13 as shown in Fig. 9. Fig. 9 is a photograph of a plan view of a trace forced into the coating layer 13, which exhibits some amount of peeling in an adhesiveness evaluation using a Rockwell diamond indenter. The coating layer 13 of Comparative example 1 is subject to peeling from the substrate 12, which causes the substrate 12 to be exposed, thus preventing efficient use of the low friction properties of the coating layer 13. Further, when the coating layer 13 of Comparative example 1 is applied to a slide member in a mechanical device, the load to the mechanical device in which the slide member moves cannot be reduced, thus failing to provide any mechanical device with a high energy efficiency.

### [Comparative Example 2]

A disk substrate 12 made of JIS SCM415 was carburized to have a surface hardness HRC not less than 58, and was finish processed to have an average surface roughness Ra not more than 0.1 µm. Then, a coating layer 13 was formed by an UBMS method while introducing inert and hydrocarbon gases. Al was not added to the coating layer 13 of Comparative example 2. When forming a gradient layer 42 positioned between a Cr intermediate layer 41 and an outermost surface layer 43 of the coating layer 13, the powers input to the Cr and C targets and the bias voltage applied to the substrate were controlled as shown in Fig. 5.

The formed coating layer 13 was evaluated for the adhesiveness by forcing the Rockwell diamond indenter into the coating layer 13 at a load of 1471 N. The result showed an excellent adhesiveness between the substrate 12 and the coating layer 13 because no peeling was observed around the trace as shown in Fig. 8. In addition, the coating layer 13 had a hardness of 30.23 GPa and a Young's modulus of 178.7 GPa. Furthermore, the coefficient of friction and the peel load of the coating layer 13 were determined to be 0.090 and 981 N respectively from the result of the friction test between the coating layer 13 and a metal ball 24 under an unlubricated condition.

On the other hand, a coating layer 13 was applied to a crown surface 53 (carburized to have an HRC value not less than 58 and finish processed to have an Ra value not more than 0.1 µm) of a motor vehicle cam lifter 52 made of JIS SCM415 by an UBMS method while introducing inert and hydrocarbon gases similarly to the case of the substrate 12. The result of the friction torque measurement in durability test under an oil lubricated condition was that in the case of Comparative example 2, the torque could be reduced by approximately 43% compared to a typical torque for motor vehicle cam lifters without the coating layer 13.

However, after the test, peeling and roughness were observed in a part of the coating layer 13 formed on the crown surface 53 as shown in Fig. 11. Fig. 11 is a result of a surface shape measurement on the coating layer 13 applied to the crown surface 53 of the motor vehicle cam lifter 52, in Comparative example 2, after the friction torque measurement in the durability test under the oil lubricated condition.

When the coating layer 13 of Comparative example 2 is applied to the cam lifter 52 for automotive engines, it is expected to be subject to peeling or increase in the coefficient of friction over time, thus preventing continuous use of the low friction properties of the coating layer 13. This fails to provide a motive power engine (such as an automotive engine) capable of maintaining a high energy efficiency over a long period of time.

### [Comparative Example 3]

A disk substrate 12 made of JIS SCM415 was carburized to have a surface hardness HRC not less than 58, and was finish processed to have an average surface roughness Ra not more than 0.1 µm. Then, a coating layer 13 was formed by an UBMS method while introducing inert and hydrocarbon gases. The coating layer 13 of Comparative example 3 was formed to contain 0.65 at.% of Al. When forming a gradient layer 42 positioned between a Cr intermediate layer 41 and an outermost surface layer 43 of the coating layer 13, the powers input to the Cr and C targets and the bias voltage applied to the substrate were controlled as shown in Fig. 7. Fig. 7 is a graph indicating a method for controlling with time powers input to the Cr and C targets and the bias voltage applied to the substrate 12 when forming the gradient layer 43 of Comparative example 3.

The formed coating layer 13 was evaluated for the adhesiveness by forcing the Rockwell diamond indenter into the coating layer 13 at a load of 1471 N. The result showed an excellent adhesiveness between the substrate 12 and the coating layer 13 because no peeling was observed around the trace as shown in Fig. 8. In addition, the coating layer 13 had a hardness of 9.378 GPa and a Young's modulus of 65.94 GPa. Furthermore, the coefficient of friction and the peel load of the coating layer 13 were determined to be 0.052 and 2452 N respectively from the results of the friction test between the coating layer 13 and a metal ball 24 under an unlubricated condition.

On the other hand, a coating layer 13 was applied to a crown surface 53 (carburized to have an HRC value not less than 58 and finish processed to have an Ra value not more than 0.1 µm) of a motor vehicle cam lifter 52 made of JIS SCM415 by an UBMS method while introducing inert and hydrocarbon gases similarly to the case of the substrate 12. The result of the friction torque measurement in durability test for Comparative example 3 under an oil lubricated condition was that the torque could not be reduced but increased by approximately 3% compared to a typical torque for motor vehicle cam lifters without the coating layer 13. In addition, after the test, some peeling was observed in the coating layer 13 formed on the crown surface 53 as shown in Fig. 12. Fig. 12 is a result of a surface shape measurement on the coating layer 13 applied to the crown surface 53 of the motor vehicle cam lifter 52, in Comparative example 3, after the friction torque measurement in the durability test under an oil lubricated condition.

When the coating layer 13 of Comparative example 3 is applied to the cam lifter 52 for automotive engines, the torque increases, and therefore the slide load between the coating layer 13 and a cam 54 cannot be reduced. Further, some peeling of the coating layer 13 occurs, thus preventing continuous use of the low friction properties of the coating layer 13. This fails to provide a motive power engine (such as an automotive engine) with a high energy efficient.

The present invention is a slide member comprising a hard carbon coating layer with excellent abrasion resistance and low friction properties and can be applied to machine components such as internal combustion engines which are used under an oil lubricated condition.

Although the invention has been described with respect to the specific embodiments for complete and clear disclosure, the appended claims are not to be thus limited but are to be construed as embodying all modifications and alternative constructions that may occur to one skilled in the art which fairly fall within the basic teaching herein set forth.

## Claims

1. A slide member, comprising:
a substrate containing at least one element selected from a group made up of V, Cr, Fe, Co, Ni, Zr, Nb, Mo, Ta, W, Ir and Pt;
a gradient layer containing chromium and carbon formed on the substrate; and
a hard carbon coating layer formed on the gradient layer; wherein:
the gradient layer has a component conformation comprising a gradually decreasing Cr concentration and gradually increasing C concentration from the substrate side to the hard carbon coating layer side; and
the hard carbon coating layer contains aluminum.

2. A slide member according to claim 1, wherein:
a chromium intermediate layer is provided between the substrate and the gradient layer.

3. A slide member according to claim 1, wherein:
the gradient layer is made of chromium carbide or chromium metal containing carbon.

4. A slide member according to claim 1, wherein:
the gradient layer has a thickness of 0.15 to 6.0 µm.

5. A slide member according to claim 1, wherein:
the hard carbon coating layer has a thickness of 0.15 to 6.0 µm.

6. A slide member according to claim 2, wherein:
the intermediate layer has a thickness of 0.03 to 1 µm.

7. A slide member according to claim 1, wherein:
the hard carbon coating layer has a surface hardness of 20 to 140 GPa.

8. A slide member according to claim 1, wherein:
the hard carbon coating layer has a surface Young's modulus of 50 to 180 GPa.

9. A slide member according to claim 1, wherein:
the hard carbon coating layer contains aluminum in an amount of 0.5 to 4.5 at.%.

10. A slide member according to claim 1, wherein:
the hard carbon coating layer contains silicon.

11. A slide member according to claim 1, wherein:
the hard carbon coating layer contains the aluminum in a form of at least one material selected from a group made up of metallic aluminum, aluminum boride, aluminum carbide, aluminum nitride, aluminum oxide and aluminum hydroxide.

12. A slide member according to claim 1, wherein:
the hard carbon coating layer has an average surface roughness of 0.1 µm or less.

13. A slide member according to claim 1, wherein:
the hard carbon coating layer contains both SP² bonded carbon and SP³ bonded carbon in an outermost surface layer thereof.

14. A method for manufacturing a slide member, comprising the steps of;
forming a chromium intermediate layer on a substrate that contains at least one element selected from a group made up of V, Cr, Fe, Co, Ni, Zr, Nb, Mo, Ta, W, Ir and Pt;
forming on the chromium intermediate layer a gradient layer containing chromium and carbon by a sputtering or ion plating method, in which the gradient layer has a component conformation comprising a gradually decreasing chromium concentration and gradually increasing carbon concentration; and
forming a hard carbon coating layer containing aluminum on the gradient layer.
